# FASCICULE DE BREVET EUROPEEN

(11) **EP 2 538 229 B1**
(45) Date de publication et mention de la délivrance du brevet: **06.05.2015**
(21) Numéro de dépôt: 12354034.6
(22) Date de dépôt: 05.06.2012
(51) Int. Cl.: G01R 1/04, G01R 25/00, G01R 19/155

(54) **Dispositif de comparaison de phases à double borne de raccordement**
Phasenvergleichsvorrichtung mit doppelter Anschlussbuchse
Phase-comparing device with dual terminal connection

(30) Priorité: 21.06.2011 FR 1101908; 21.06.2011 FR 1101907
(43) Date de publication de la demande: 26.12.2012
(73) Titulaire: Schneider Electric Industries SAS, 92500 Rueil-Malmaison (FR)
(72) Inventeur: Caous, Philippe, 38050 Grenoble Cedex 09 (FR); Mollier, Christophe, 38050 Grenoble Cedex 09 (FR); Bordonado, Franck, 38050 Grenoble Cedex 09 (FR)
(74) Mandataire: Péru, Laurence

(56) Documents cités:
- EP-A1- 0 438 689
- DE-A1- 4 109 943
- DE-A1- 4 413 697
- DE-A1- 19 610 448
- US-A- 5 686 840
- US-B1- 7 417 437
- "Accessories for voltage indicators and Electronic Phase Comparator EPC", , 1 août 2005 (2005-08-01), pages 1-4, XP055019764, Extrait de l'Internet: URL:http://mv.eii-bg.com/Kuwag/pdf/accesso ries universal cpi eng_www.pdf [extrait le 2012-02-17]
- "High-Voltage Testers - Phase Comparators - High-Voltage Indicators - Single Probe Phase Comparators", , 28 janvier 2010 (2010-01-28), pages 1-11, XP055019768, Extrait de l'Internet: URL:http://www.mvtech.com.au/catalogues/HV Testers,Indicators&PhaseComparators_Horstm ann.pdf [extrait le 2012-02-17]
- "SM6-MC500. Notice de kit - Adaptateur comparateur de phases pour boitiers VPIS", , 6 août 2008 (2008-08-06), pages 0-10, XP055019765, Extrait de l'Internet: URL:http://www.global-download.schneider-e lectric.com/85257578007E5C8A/all/0143DC54A 4C3C72488257578006722EB/$File/7897381fe.pd f [extrait le 2012-02-17]
- "Additive for SM6 cubicle ( VPIS--V1 and VPIS--V2 and phase concordance unit", , 18 mai 2009 (2009-05-18), pages 1-10, XP055019767, Extrait de l'Internet: URL:http://www.global-download.schneider-e lectric.com/852575A6007E5FD3/all/6AF0173F6 95F0C4E852575BA00697DB2/$File/bbv5369201_0 2.pdf [extrait le 2012-02-17]

## Description

### DOMAINE TECHNIQUE

L'invention concerne les comparateurs utilisés pour vérifier la concordance de phases, notamment entre deux appareillages moyenne tension, par exemple pour des réseaux électriques de 3 à 40 kV et 50 Hz ou 60 Hz. Plus particulièrement, l'invention se rapporte à une gestion optimisée de l'énergie d'un indicateur de phase pour minimiser sa consommation et/ou d'un comparateur de phase pour en outre permettre une auto-alimentation via les dispositifs indicateurs de tension sur lesquels ils sont connectés. L'invention se rapporte aussi au système de raccordement des comparateurs pour permettre une utilisation plus simple dans le cas où les indicateurs de tension n'ont pas les mêmes caractéristiques de sortie.

### ETAT DE LA TECHNIQUE

Dans les appareillages moyenne tension (MT), pour s'assurer qu'un système est hors ou sous tension, des détecteurs de tension conformes à la norme CEI 61243 sont mis en place. Pour fournir des informations sur l'état de tension du circuit principal de l'appareillage, ces détecteurs sont associés à des dispositifs indicateurs de tension, communément appelés VPIS (« *Voltage Presence Indicating System* ») ; leur fonctionnement est défini par la norme CEI 61958

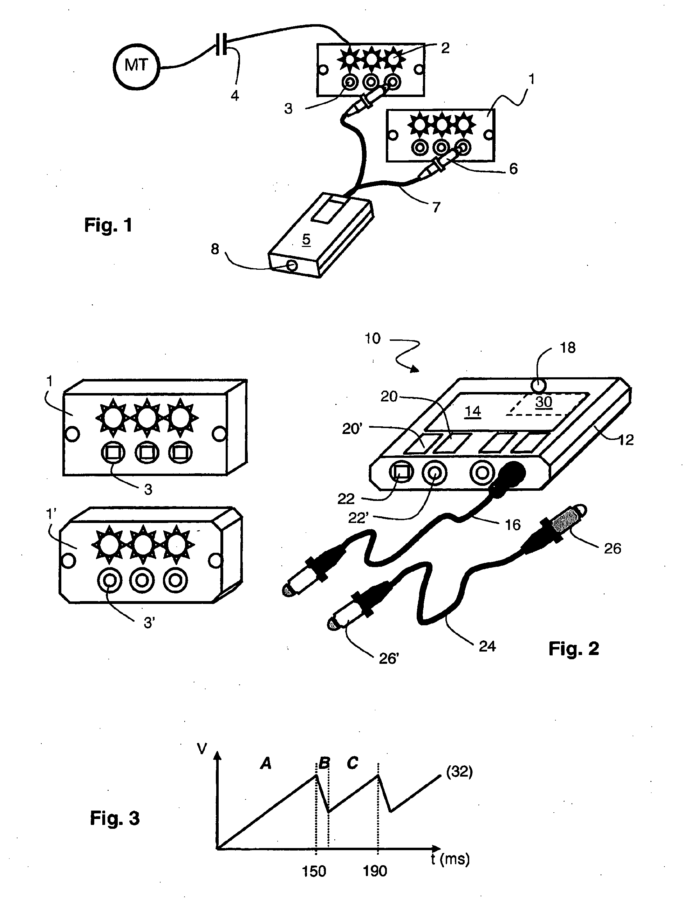

Tel que schématisé en figure 1, un VPIS 1 indique au moyen de voyants 2 la présence d'une tension sur chacune des phases A, B, C. Parallèlement, un signal représentatif de cette tension est accessible depuis une borne 3 du VPIS, classiquement sur la même face avant du VPIS que les voyants 2 et en regard de ces derniers ; la tension disponible depuis la borne 3 est divisée par le pont capacitif 4 réalisé par la capacité de traversée présente dans les cellules, et faible.

La borne 3 peut être raccordée à un système externe ; en particulier, pour confirmer la relation de phase entre deux appareillages MT, deux VPIS 1 sont communément couplés à un comparateur de phase 5, auquel la norme précédente CEI 61958 s'applique également. Un comparateur de phase 5 qui comprend des terminaux 6 complémentaires des bornes 3 se connecte en face avant des VPIS 1 de deux cellules MT pour vérifier la correspondance directe entre chaque phase A, B, C des cellules, afin d'éviter de croiser les phases, par exemple lors du raccordement entre deux cellules pour des besoins de reconfiguration du réseau MT. De façon usuelle, les terminaux 6 du comparateur 5 sont localisés à l'extrémité de câbles 7 prolongeant une face, de préférence un petit côté, du boîtier du dispositif de comparaison 5.

Le système électronique du comparateur 5 peut détecter les écarts de phase seuls ou conjointement avec les écarts de fréquence ; il génère un signal de sortie proportionnel à la différence de phase entre deux signaux d'entrée. Ce signal de sortie est, quelle que soit sa nature, transmis entre autres à des moyens 8 indicateurs d'une différence de phase, afin de prévenir l'utilisateur et éviter tout problème.

Au vu des implications de l'information transmise par un comparateur de phase 5, celui-ci répond à des conditions strictes de certification. En particulier, une « discordance de phase » doit être affichée si le décalage de phase entre les tensions phase-terre est supérieur à 30°, ce seuil pouvant être modifié d'un commun accord entre constructeur et utilisateur en fonction de l'utilisation envisagée. L'indication de la discordance de phase doit être réalisée sur une durée suffisante, par des signaux actifs : au minimum, l'indication concerne un éclairage 8 dont le signal émis est permanent, ou correspond à au moins un flash par seconde, tant que le comparateur 5 est branché. En outre, l'indication certaine d'un comparateur de phase 5 ne doit pas être affectée par la différence entre les signaux fournis par les points de connexion, susceptible par exemple de provenir d'une différence entre les tensions de service ou des tolérances de construction des VPIS 1. L'électronique d'un comparateur de phase 5 est donc complexe, et gourmande en énergie.

Pour permettre de remplir ces conditions, une solution classique consiste à utiliser une batterie qui alimente les circuits et voyants du comparateur de phase 5. L'inconvénient inhérent à ce type de solution est la vérification de l'état de charge de la batterie.

Il est de fait préférable que le comparateur de phase ne soit pas dépendant d'une alimentation externe, par exemple en l'activant par les signaux des VPIS, qui sont cependant eux aussi soumis à de fortes contraintes sur leur consommation interne. Les courants d'alimentation alors disponibles pour le comparateur 5 sont très faibles, de l'ordre de quelques microampères. Or l'électronique des comparateurs 5 est usuellement lourde et complexe, incompatible avec ce type d'alimentation : voir par exemple US 6 087 856, CA 2 290 862 ou US 6 300 803. La gestion de l'énergie et de l'éclairage des comparateurs doit donc être optimisée.

Qui plus est, il est souhaitable que le comparateur 5 puisse être adapté à plusieurs générations de VPIS 1, qui sont intégrés dans les postes MT. Or il apparaît que la connectique 3 disponible en face avant peut différer entre les VPIS, avec notamment des bornes de câblage différentes. Il est usuel de disposer d'adaptateurs mécaniques permettant de coupler le terminal du dispositif de comparaison avec la borne du VPIS, et/ou d'adaptateur électronique permettant d'uniformiser la forme du signal issu du VPIS et transmis aux moyens de comparaison. Cependant, cette solution reste lourde.

### EXPOSE DE L'INVENTION

Parmi autres avantages, l'invention vise à pallier des inconvénients des comparateurs de phase existants. En particulier, sous un de ses aspects, l'invention concerne un dispositif de comparaison de phase dans lequel les moyens de raccordement permettent le traitement pour deux types de VPIS différents, sans utilisation d'ancillaires ; l'invention concerne également un dispositif de comparaison de phase dans lequel la gestion de l'éclairage de la diode d'alerte est optimisée pour permettre une auto-alimentation.

En particulier, l'invention se rapporte à un dispositif de comparaison de phase dans lequel les moyens de raccordement sur une source externe sont dédoublés de façon à permettre une connexion sur deux types de bornes différents, et donc deux indicateurs de tension de type VPIS de gamme différente.

Notamment, le dispositif de comparaison comprend des premiers et deuxièmes moyens pour obtenir un signal représentatif de deux tensions de phase, avantageusement associés à un système de traitement électronique, des moyens de comparaison des premier et deuxième signaux représentatifs des tensions de phase, des moyens pour indiquer le résultat de la comparaison, par exemple une diode électroluminescente ; chacun des moyens pour obtenir un signal représentatif d'une tension de phase comprend deux bornes de raccordement et un câble muni à chaque extrémité d'un terminal de raccordement complémentaire de chacune des bornes. Le câble peut être monté imperdable sur le boîtier du dispositif.

Dans un mode de réalisation préféré, les bornes d'un même moyen pour obtenir un signal représentatif d'une tension de phase sont mécaniquement différentes, et les deux moyens pour obtenir un signal représentatif sont identiques. Les bornes peuvent être alignées sur un côté du boîtier, de préférence opposé aux moyens indicateurs du résultat.

Avantageusement, le dispositif de comparaison de phase à diode électroluminescente selon l'invention comprend des moyens d'alimentation et de gestion de la diode par l'intermédiaire des signaux représentatifs des tensions de phase, lesdits moyens étant adaptés pour alimenter la diode de façon intermittente ; de préférence, des moyens de redressement de la tension sont prévus.

Afin d'assurer l'alimentation intermittente, les moyens d'alimentation et de gestion comprennent de préférence des moyens d'interruption de la tension d'alimentation de la diode, par exemple un transistor, et des moyens de stockage d'énergie, par exemple une capacité, qui commandent, en fonction de l'énergie qui y est stockée, les moyens d'interruption. Les moyens d'alimentation et de gestion sont avantageusement électroniques, les composants du circuit électrique desdits moyens étant choisis pour définir les étapes de l'alimentation.

De préférence, les étapes de l'alimentation de la diode comprennent une charge préalable des moyens de stockage jusqu'à au moins une valeur de charge, puis de façon alternée et itérative, un allumage pendant une première période pendant laquelle les moyens d'interruption sont passants et les moyens de stockage se déchargent partiellement pour alimenter la diode, et une recharge pendant une deuxième période pendant laquelle les moyens d'interruption ne sont pas passants et les moyens de stockage se rechargent jusque la valeur de charge. Pour assurer un éclairage continu de la diode, la deuxième période a une durée inférieure à 50 ms.

### BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.
La figure 1, déjà décrite, illustre l'utilisation d'un comparateur de phase avec deux VPIS.
La figure 2 montre un mode de réalisation préféré d'un comparateur de phase selon l'invention, adapté pour deux VPIS différents.
La figure 3 représente les phases d'allumage de la LED indicatrice d'un comparateur et d'un indicateur selon un mode de réalisation de l'invention.
La figure 4 montre un mode de réalisation du circuit de gestion de l'alimentation de la LED selon un mode de réalisation de l'invention.

### DESCRIPTION DETAILLEE D'UN MODE DE REALISATION PREFERE

Le comparateur 10 selon l'invention permet de se connecter en face avant de VPIS 1, au niveau des sorties 3 indiquant la présence de tension sur chacune des phases de deux équipements moyenne tension. Le dispositif de comparaison des phases 10 comprend, de manière usuelle, un boîtier 12 comprenant des moyens de comparaison électronique 14, de préférence une carte de circuit imprimé, qui reçoivent des signaux représentatifs de la phase de deux origines via des moyens de raccordement 16, et donnent pour résultat un signal correspondant à un déclenchement de moyens d'avertissement 18 si une différence, par exemple plus de 30° d'écart, est constatée entre les deux signaux d'entrée.

Les moyens de comparaison 14 selon l'invention peuvent utiliser les différents systèmes existants, et les dispositifs de comparaison à trois états, à bascule JK, à multiplicateur de Gilbert ou à porte XOR peuvent être concernés par la solution selon l'invention ; de préférence, la carte de circuit imprimé 14 comprend des moyens pour donner un résultat de déclenchement par accumulation d'énergie suffisante dans une capacité réservoir par l'intermédiaire d'un circuit électronique de redressement lorsque deux signaux représentatifs d'une phase correspondant à des tensions affichant une discordance angulaire de plus de 30° lui sont communiqués.

En particulier, le signal résultant du traitement par les moyens de comparaison 14 est transmis à un voyant 18 qui s'allume lorsque la comparaison est positive, c'est-à-dire lorsque les phases sont discordantes ; le voyant 18 est de préférence unique, avec éclairage seulement en cas de défaut détecté, mais suivant les résultats disponibles par la comparaison et le courant d'alimentation disponible, il peut y avoir plusieurs voyants et/ou modification de la couleur de l'éclairage et/ou une alarme sonore additionnelle.

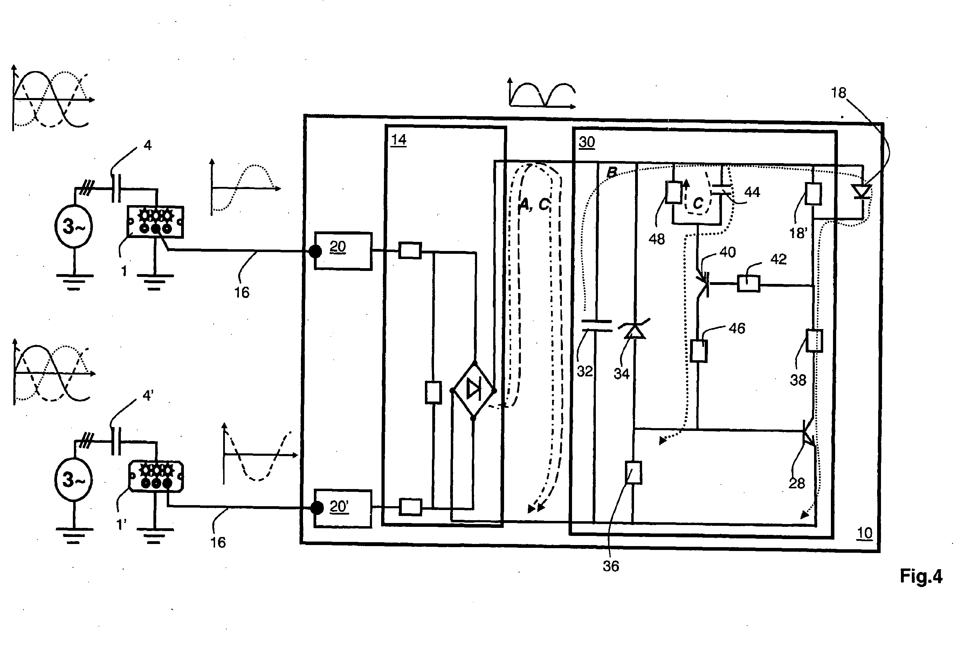

Pour obtenir les deux signaux d'entrée des moyens de comparaison 14, représentatifs d'une phase, le dispositif de comparaison 10 est muni de deux moyens de raccordement 16 dotés de terminaux qui peuvent être insérés dans une borne 3 de chacun des VPIS 1 pour fournir le signal aux moyens de comparaison 14. Comme le comparateur de phase 10 selon l'invention est à alimentation autonome à travers les VPIS 1, les signaux représentatifs des phases obtenus via les moyens de raccordement 16 du comparateur 10 sont traités préalablement à leur entrée dans les moyens de comparaison 14. Notamment, chaque entrée 16 est associée à un système électronique d'adaptation 20 d'un signal provenant d'un VPIS 1. Par ailleurs (voir aussi figure 4), un pont de diodes est mis en place pour un étage de redressement double alternance permettant de fournir une alimentation continue nécessaire au bon fonctionnement du comparateur de phase 10 ; avantageusement, cet étage de redressement permet la comparaison entre les deux signaux d'entrée : lors du redressement, si les deux phases concordent, le signal de sortie et d'alimentation est nul, ou très faible, insuffisant pour alimenté le voyant 18.

Il arrive fréquemment que les cellules MT dont les phases doivent être comparées aient été mises en place séparément et/ou proviennent de constructeurs variés. En particulier, les VPIS 1, 1' intégrés à ces cellules peuvent être de génération différente, et fournir des signaux sous forme variable, par l'intermédiaire de connecteurs 3, 3' qui ne sont pas compatibles. Dans un mode de réalisation préféré de l'invention, le dispositif de comparaison 10 est adapté pour deux types de VPIS 1, 1', notamment pour les deux générations VPIS V1 et VPIS V2-VPI6240x.

A cette fin, les terminaux de connexion aux VPIS 1, 1' sont dissociés du boîtier 12 du dispositif de comparaison 10. Le boîtier 12 est muni à la place, de préférence sur la même face et pour chacun des moyens de raccordement 16, de bornes 22, 22' de connexion similaires à celles des deux générations de VPIS 1, 1' préférées. Notamment, pour chaque entrée d'un signal représentatif d'une phase, le dispositif de comparaison 10 comprend une première borne 22 similaire à celle 3 d'un VPIS 1 de la première génération, par exemple de type à contact en fond de canon, et une deuxième borne 22' similaire à celle 3' d'un VPIS 1' de la deuxième génération, par exemple de type à contact sur les côtés du canon.

La transmission de signal est réalisée par l'intermédiaire de câbles 24 dont les deux extrémités sont munies de terminaux 26, 26' différents, respectivement adaptés aux bornes 3, 22 de première génération et 3', 22' de deuxième génération. Les câbles 24 sont d'abord couplés à une extrémité aux VPIS 1, 1' à analyser, le terminal 26, 26' restant étant connecté au dispositif de comparaison 10 par la borne 22', 22 adaptée. Afin de remplir les conditions de traitement, on note que chaque borne 22, 22' du dispositif de comparaison 10 est donc associée, s'il y a lieu, au système électronique de traitement 20', 20 correspondant au VPIS 1', 1 de l'autre type de borne.

Dans un mode de réalisation avantageux, les câbles 24 sont rendus imperdables par intégration d'un passe câbles, ou autre système de fixation, dans le boitier 12.

Il est donc possible grâce à cette solution de raccorder un comparateur de phases 10 sur des dispositifs VPIS 1, 1' de génération différente, dans chacune des configurations (deux VPIS 1 de première version, deux VPIS 1' de deuxième version, et un VPIS 1 de première version avec un VPIS 1' de deuxième version) et dont la connectique et/ou l'électronique diffèrent, ceci sans accessoire additionnel de type adaptateur mécanique et/ou électronique, et sans nécessiter de choix d'électronique via un commutateur rotatif ou un micro-switch ou tout autre élément électromécanique.

Le signal issu des VPIS 1, 1', transmis au dispositif de comparaison de phase 10, est traité pour fournir un résultat correspondant à un signal de déclenchement de moyens indicateurs de défaut 18. Selon l'invention, l'information de l'utilisateur est réalisée principalement par éclairage d'une diode électroluminescente, ou LED 18 ; de préférence, la LED est de couleur rouge et localisée sur la face opposée aux moyens de raccordement 16 du comparateur de phases 10.

Au vu du faible courant de commande disponible, l'allumage de la LED 18 est réalisé par l'intermédiaire d'un transistor 28 utilisé comme interrupteur commandé. De plus, afin de minimiser l'énergie nécessaire, la LED 18 n'est éclairée que de façon pulsée, en exploitant le phénomène de persistance rétinienne : si deux périodes d'éclairage successifs sont séparées d'une extinction inférieure à 40 ou 50 ms, l'allumage semble ininterrompu pour l'oeil. Des moyens 30 de gestion de l'alimentation de la LED 18 sont donc prévus.

Afin de pouvoir assurer une accumulation de charge électrique suffisante pour le reste du circuit électrique et au vu des faibles courants extraits des VPIS 1, 1', eux-mêmes alimentés sur les capacités de traversée 4, 4', des moyens de stockage d'énergie 32 sont utilisés en sortie du pont de diodes ; en particulier, les moyens de stockage sont une capacité de l'ordre de C₃₂ = 22 nF.

Le comparateur selon l'invention comprend ainsi des moyens 30 de gestion de l'éclairage de la LED 18 permettant de procéder en trois étapes, tel qu'illustré en figure 3 :
- une étape *A* de précharge permettant de remplir des moyens de stockage d'énergie 32 de manière à disposer de suffisamment d'énergie pour allumer furtivement la LED 18, sans pour autant les vider ;
- une étape *B* d'allumage très courte de la LED ;
- une étape *C* de recharge des moyens de stockage 32, de manière à disposer de suffisamment d'énergie pour allumer furtivement la LED 18, sans pour autant les vider.

Les durées de chacune des étapes sont calculées de manière à optimiser la consommation énergétique du dispositif 10. Notamment, selon l'invention, les moyens de stockage 32 ne sont pas déchargés complètement lors de l'étape d'allumage *B*, afin d'écourter la phase de recharge et d'assurer un rapport cyclique plus court. Ce choix permet de jouer sur la persistance rétinienne pour assurer l'illusion d'un allumage ininterrompu du voyant 18 : de fait, une recharge complète de moyens de stockage 32 de l'énergie nécessaire à l'allumage d'une LED 18 nécessite de l'ordre de 150 ms, soit plus que la persistance rétinienne.

Par ailleurs, les composants du système de gestion 30 du comparateur 10 selon l'invention sont dimensionnés pour pouvoir être facilement être adaptés à un dispositif clignotant, en procédant alors à une modification des durées des différentes étapes : par exemple, la recharge peut être plus longue que 50 ms, avec ajustement selon la fréquence de clignotement souhaitée.

Un mode de réalisation préféré du circuit de traitement électronique des signaux du comparateur selon l'invention est illustré en figure 4.

Lors du branchement du dispositif de comparaison 10 selon l'invention sur les VPIS 1, 1', la charge du réservoir d'énergie 32 est nulle. Lors de la première étape *A*, la capacité 32, en parallèle d'un circuit commandé par des moyens d'interruption 34 de type diode, va se charger jusqu'à ce que la tension Zener soit atteinte, par exemple 10 V pour le mode de réalisation préféré : tant que cette tension n'est pas atteinte au niveau de la capacité 32, le courant dans la diode 34 et donc dans le reste du circuit reste nul. Cette étape de précharge *A* dure environ 150 ms au-delà desquelles la tension est atteinte et la diode Zener 34 devient passante.

Un courant peut alors circuler dans le circuit commandé par la diode 34 et dans la résistance 36, entraînant la polarisation de la base du transistor NPN 28 ; pour que cette polarisation soit quasi-immédiate, on utilise de préférence un transistor 28 de gain environ 300 qui peut être polarisé par quelques centaines de microampères de courant de base. La capacité 32 peut alors se décharger dans la LED 18 à travers la branche de droite sur la figure 4 (étape *B*) : ce n'est plus la diode 34 qui supporte la tension d'environ 10 V mais la LED 18 qui s'allume.

De préférence, la LED 18 est de type LST67K au vu de ses performances de haute luminosité ; avantageusement, une résistance 18' est mise en parallèle pour éviter tout effet photodiode. Comme son courant direct typique est de 2 à 20 mA pour une chute de tension donnée pour 1,7 à 2,2 V, une résistance de limitation 38 lui est associée dimensionnée de façon à tenir la différence entre la tension aux bornes de la capacité 32 et les chutes de tension générées par la LED 18 et le NPN 28, soit 370 ohm, correspondant à une valeur normalisée de R₃₈ = 392 Ω.

Durant cette étape *B* de conduction de la LED 18, un courant beaucoup plus important que ceux auparavant prélevés sur la capacité 32 (20 mA contre des courants toujours inférieurs à 1 mA) circule, sous une chute de tension d'environ 2 V. Dans la mesure où l'invention vise une auto-alimentation du circuit, pour éviter ces phases de « dépense énergétique », un second circuit à transistor PNP 40 est utilisé : dès lors que la LED 18 est devenue passante, la chute de tension à ses bornes se reporte sur la base de ce transistor 40, qui est quasi-immédiatement polarisé à travers sa résistance 42, et rendant de fait le transistor PNP 40 passant. Les moyens de stockage 32 ont alors deux chemins de décharge, l'un à travers la LED 18, l'autre à travers le transistor PNP 40, permettant la charge d'une capacité tampon 44.

Ce double circuit de décharge va perdurer jusqu'à ce que la chute de tension passante aux bornes de la LED 18 (soit 2 V) devienne inférieure à la somme des tensions du transistor PNP 40 (typiquement 0,6 V pour une jonction P/N silicium) et de charge de la capacité tampon 44 : en d'autres termes, cela signifie que dès que la tension aux bornes de la capacité tampon 44 atteint 1,4 V, la LED 18 n'est plus passante et donc s'éteint. La durée de cette étape *B*, environ 20 µs dans le cas illustré, est liée à la chute de tension à l'état passant de la LED 18 et conditionne le dimensionnement des composants du circuit RC 44, 46 de décharge des moyens de stockage 32.

Lors de l'étape d'allumage *B* de la LED 18, de l'énergie s'est accumulé dans la capacité tampon 44, qu'il faut évacuer. Or l'ouverture de la LED 18 entraîne la dépolarisation de la base du transistor PNP 40 de pincement, et la capacité tampon 44 se décharge dans la résistance 48 en parallèle, jusqu'à épuisement de la charge accumulée.

Parallèlement à cette décharge, l'étape *C* comprend la recharge des moyens de stockage 32, dont la charge s'est de fait partiellement transférée vers la capacité tampon 44 dans l'étape précédente *B* : la tension aux bornes de la capacité de stockage 32 est ainsi passée de 10,2 V à 6,6 V dans l'exemple illustré. Comme cette capacité 32 est partiellement pleine, l'étape de recharge *C* est plus courte que l'étape initiale *A*, mais est réalisée avec le même circuit de charge, donc selon la même pente.

Les deux phénomènes, à savoir la décharge de la capacité tampon 44 dans la résistance 48 et la recharge de la capacité de stockage 32, ont lieu simultanément lors de la troisième étape *C* : le dimensionnement des composants 32, 44, 48 est donc choisi de manière à ce que les résultats de chacune soient simultanés. Par ailleurs, comme on retrouve l'étape *B* à l'issue de la recharge et donc une LED 18 passante, les composants du circuit tampon 44, 48 sont dimensionnés de façon à ce que la troisième étape de recharge *C* corresponde à la durée de persistance rétinienne, de sorte que l'utilisateur a alors l'illusion que la LED 18 est allumée en permanence. Pour une couleur primaire comme le rouge, cette durée est d'environ 40 à 50 ms ; elle est légèrement plus faible pour des couleurs composées.

Ainsi dans l'exemple, avec R₄₈ = 1,5 MΩ et C₄₄ = 10 nF, on est à une valeur théorique de τ = 15 ms ; en pratique, on choisit un peu plus de trois fois cette constante de temps pour décharger à 97 % : avec une phase de décharge de la capacité tampon 44 maintenue pendant 52 ms, on passe de 1,4 à 0,04 V.

Pour les autres éléments du circuit, résistances 42, 36, 46 comme capacité 32, les valeurs sont définies par le fait que les moyens de stockage 32 passent simultanément de 6,8 V à 10,2 V, avec la même pente que lors de la première étape *A* ; il est possible de modifier les valeurs en fonction des exigences relatives au temps de réponse du dispositif 10 (délai de premier allumage du voyant 18 par exemple pour un dispositif clignotant).

De fait, en faisant abstraction de l'étape A de précharge, la LED 18 n'est allumée que 20 µs toutes les 50 ms, et voit alors passer une impulsion de courant de 20 mA : ainsi avec un courant moyen de 8 pA, on maintient l'illusion d'une LED 18 allumée en permanence. Or selon ses caractéristiques techniques, la LED utilisée ne peut être utilisée de façon pulsée à moins de 1 s pour 20 mA et ne répond à des impulsions qu'avec 100 mA de valeur maximale et un cycle d'impulsion d'au moins 0,005 : la solution selon l'invention permet un cycle 12,5 fois plus faible tout en restant à un courant égal à la valeur minimale indiquée. La consommation est ainsi drastiquement réduite, ce qui permet une alimentation autonome.

Grâce aux différents choix selon l'invention, et notamment du fait de pulser les signaux plutôt que d'alimenter la LED 18 en continu, en jouant sur la rémanence de l'oeil, du fait de procéder en trois étapes successives de précharge/allumage/recharge sans vider totalement les réservoirs en phase d'allumage, et du fait de dimensionner les différents éléments du circuit malgré l'imbrication des composants dans les différentes étapes, une forte fréquence de clignotement conjointe avec une faible puissance nécessaire, et donc une alimentation conforme à celle disponible directement par les signaux indicateurs d'un VPIS sont possibles pour un comparateur de phase 10. En particulier, les caractéristiques suivantes ont été obtenues :

| | Puissance nécessaire | Fréquence de clignotement |
|---|---|---|
| Comparateur de phase Schneider V1-51191954FA | 2985 µW | 2 Hz |
| Comparateur de phase ABB PCM | 526 µW | 1 Hz |
| Mode de réalisation préféré selon l'invention | 211 µW | 4 Hz |

Le comparateur de phase selon l'invention présente ainsi les caractéristiques suivantes :
- il est conforme à la norme en vigueur ;
- son électronique est conçue pour être à ultra basse consommation ;
- il est autonome et auto-alimenté ;
- il peut être utilisé avec des VPIS de deux types de connectiques différents.

Bien que l'invention ait été décrite en référence à un dispositif de comparaison de phase avec simple diode d'éclairage de défaut, elle ne s'y limite pas : d'autres éléments peuvent être concernés, et notamment le comparateur peut être muni d'autres moyens d'avertissement de type signal sonore, les moyens de comparaison pouvant par ailleurs fournir deux signaux différents pour alimenter deux moyens indicateurs selon la différence de phase constatée.

En particulier, le mode de gestion de l'alimentation décrit est adapté pour utilisation sur un VPIS : pour de tels dispositifs d'indication de phase, le signal représentatif de la tension obtenu via la capacité de traversée 4, 4'est entré dans des moyens de comparaison avec un seuil (en lieu et place des moyens de redressement 14) ; le signal issu des moyens de comparaison est entré dans les moyens de gestion de l'alimentation 30 de la même façon.

Un comparateur de phase selon l'invention peut en outre être associé à un adaptateur mécanique incluant une électronique d'adaptation du signal pour gérer des VPIS d'autres gammes que celles prévues et gérées par le câble réversible. Le comparateur selon l'invention peut également être à plusieurs étages, avec option entre deux niveaux de tension de réseau prévus par les moyens électroniques et un commutateur, rotatif ou autre, de sélection de la tension sur chaque voie de raccordement.

## Revendications

1. Dispositif de comparaison de phase (10) comprenant un boîtier (12), des premiers moyens (16) pour obtenir un signal représentatif d'une première tension de phase, des deuxièmes moyens (16) pour obtenir un signal représentatif d'une deuxième tension de phase, des moyens (14) de comparaison des signaux représentatifs des première et deuxième tensions de phase, des moyens (18) pour indiquer le résultat de la comparaison, **caractérisé en ce que** chacun des moyens (16) pour obtenir un signal représentatif d'une tension de phase comprend deux bornes de raccordement de type différent (22, 22') et un câble (24) muni à chaque extrémité d'un terminal de raccordement (26, 26') complémentaire de chacune des bornes (22, 22') dudit moyen (16).

2. Dispositif selon la revendication 1 dans lequel les bornes (22, 22') d'un même moyen pour obtenir un signal représentatif d'une tension de phase sont mécaniquement différentes.

3. Dispositif selon l'une des revendications 1 à 2 dans lequel chaque borne (22, 22') est associée à un système de traitement électronique (20, 20') permettant de fournir des données aux moyens de comparaison (14).

4. Dispositif selon l'une des revendications 1 à 3 dans lequel les premiers et deuxièmes moyens (16) pour obtenir un signal représentatif sont identiques.

5. Dispositif selon l'une des revendications 1 à 4 dans lequel les bornes (22, 22') des premiers et deuxièmes moyens (16) pour obtenir un signal représentatif sont alignées sur un côté du boîtier (12) du dispositif.

6. Dispositif selon l'une des revendications 1 à 5 dans lequel les câbles (24) sont montés imperdables sur le boîtier (12) par l'intermédiaire de systèmes de fixation.

7. Dispositif selon l'une des revendications 1 à 6 dans lequel les moyens (18) pour indiquer le résultat de la comparaison comprennent une diode électroluminescente localisée sur un côté du boîtier (12), les bornes (22, 22') étant localisées sur un autre côté, de préférence opposé, du boîtier (12).

8. Dispositif selon la revendication 7 comprenant des moyens (30) d'alimentation et de gestion de la diode (18) par l'intermédiaire des signaux représentatifs des courants de phase, lesdits moyens (30) étant adaptés pour alimenter la diode (18) de façon intermittente, la deuxième période séparant deux périodes d'allumage de la diode (18) ayant une durée inférieure à 50 ms.

9. Dispositif selon la revendication 8 comprenant des moyens de redressement double alternance.

10. Dispositif selon l'une des revendications 8 ou 9 dans lequel les moyens d'alimentation et de gestion (30) comprennent des moyens (28) d'interruption du courant d'alimentation de la diode (18) et des moyens de stockage d'énergie (32), lesdits moyens d'interruption (28) étant commandés en fonction de l'énergie disponible dans les moyens de stockage (32).

11. Dispositif selon la revendication 10 dans lequel les moyens d'alimentation et de gestion sont adaptés pour que, après que les moyens de stockage (32) ont été chargés au moins à une valeur de charge (C₃₂), l'alimentation de la diode (18) se réalise selon les étapes itératives :
- allumage (B) pendant une première période pendant laquelle les moyens d'interruption (28) sont passants et les moyens de stockage (32) se déchargent partiellement pour alimenter la diode (18) ;
- recharge (C) pendant une deuxième période pendant laquelle les moyens d'interruption (28) ne sont pas passants et les moyens de stockage (32) se rechargent jusque la valeur de charge (C₃₂).

12. Dispositif selon l'une des revendications 10 ou 11 dans lequel les moyens d'alimentation et de gestion (30) sont électroniques, les composants du circuit électronique desdits moyens étant adaptés pour définir les étapes de l'alimentation.

13. Dispositif selon l'une des revendications 10 à 12 dans lequel les moyens de stockage (32) sont une capacité et les moyens d'interruption (28) sont un transistor.

## Patentansprüche

1. Phasenvergleichsvorrichtung (10) mit einem Gehäuse (12), ersten Mitteln (16) zur Erfassung eines, eine erste Phasenspannung abbildenden Signals, zweiten Mitteln (16) zur Erfassung eines, eine zweite Phasenspannung abbildenden Signals, Vergleichsmitteln (14) zum Vergleich der die erste und die zweite Phasenspannung abbildenden Signale sowie Mitteln (18) zur Anzeige des Vergleichsergebnisses, **dadurch gekennzeichnet, dass** jedes der Mittel (16) zur Erfassung eines eine Phasenspannung abbildenden Signals zwei Anschlussklemmen unterschiedlichen Typs (22, 22') sowie ein Kabel (24) umfasst, das an jedem Ende einen, jeder der Klemmen (22, 22') des genannten Mittels (16) zugeordneten Anschlussstecker (26, 26') umfasst.

2. Vorrichtung nach Anspruch 1, bei der die Klemmen (22, 22') jeweils eines Mittels zur Erfassung eines eine Phasenspannung abbildenden Signals mechanisch unterschiedlich ausgeführt sind.

3. Vorrichtung nach einem der Ansprüche 1 bis 2, bei der jede Klemme (22, 22') einer elektronischen Verarbeitungsschaltung (20, 20') zugeordnet ist, welche Schaltung Daten an die Vergleichsmittel (14) liefern kann.

4. Vorrichtung nach einem der Ansprüche 1 bis 3, bei der das erste und das zweite Mittel (16) zur Erfassung eines spannungsabbildenden Signals identisch ausgeführt sind.

5. Vorrichtung nach einem der Ansprüche 1 bis 4, bei der die Klemmen (22, 22') des ersten und des zweiten Mittels (16) zur Erfassung eines spannungsabbildenden Signals an einer Seite des Gehäuses (12) fluchtend miteinander angeordnet sind.

6. Vorrichtung nach einem der Ansprüche 1 bis 5, bei der die Kabel (24) mit Hilfe von Befestigungssystemen unverlierbar am Gehäuse (12) angebracht sind.

7. Vorrichtung nach einem der Ansprüche 1 bis 6, bei der die Mittel (18) zur Anzeige des Vergleichsergebnisses eine Leuchtdiode umfassen, die an einer Seite des Gehäuses (12) angeordnet ist, wobei die Klemmen (22, 22') an einer anderen, vorzugsweise der gegenüberliegenden Seite des Gehäuses (12) angeordnet sind.

8. Vorrichtung nach Anspruch 7 mit Mitteln (30) zur Stromversorgung und Ansteuerung der Diode (18) über die Phasenströme abbildenden Signale, welche Mittel (30) so ausgelegt sind, dass sie eine intermittierende Stromversorgung der Diode (18) bewirken, wobei die Dauer des zwischen zwei Leuchtintervallen der Diode (18) liegenden zweiten Zeitintervalls unter 50 ms beträgt.

9. Vorrichtung nach Anspruch 8, die Zweiweg-Gleichrichtmittel umfasst.

10. Vorrichtung nach Anspruch 8 oder 9, bei der die Stromversorgungs- und Steuermittel (30) Mittel (28) zur Unterbrechung der Stromversorgung der Diode (18) sowie Energiespeichermittel (32) umfassen, wobei die genannten Unterbrechungsmittel (28) in Abhängigkeit von der in den Speichermitteln (32) verfügbaren Energie angesteuert werden.

11. Vorrichtung nach Anspruch 10, bei der die Stromversorgungs- und Steuermittel so ausgelegt sind, dass nach dem Aufladen der Energiespeichermittel (32) auf mindestens einen Ladungswert (C32) die Stromversorgung der Diode (18) in aufeinanderfolgenden Phasen erfolgt:
- Aufleuchten (B) während eines ersten Zeitintervalls, in dessen Verlauf die Unterbrechungsmittel (28) leitend sind und die Energiespeichermittel (28) sich teilweise entladen, um die Stromversorgung der Diode (18) zu gewährleisten;
- Wiederaufladung (C) während eines zweiten Zeitintervalls, in dessen Verlauf die Unterbrechungsmittel (28) nichtleitend sind und die Energiespeichermittel (28) bis auf den Ladungswert (C32) wieder aufgeladen werden.

12. Vorrichtung nach Anspruch 10 oder 11, bei der die Stromversorgungs- und Steuermittel (30) elektronisch ausgeführt und die Komponenten der elektronischen Schaltung der genannten Mittel dazu ausgelegt sind, die zeitlichen Phasen der Stromversorgung zu steuern.

13. Vorrichtung nach einem der Ansprüche 10 bis 12, bei der die Energiespeichermittel (32) als Kondensator und die Unterbrechungsmittel (28) als Transistor ausgeführt, sind.

## Claims

1. Phase comparison device (10) comprising a casing (12), first means (16) for obtaining a signal representative of a first phase voltage, second means (16) for obtaining a signal representative of a second phase voltage, means (14) for comparison of the signals representative of the first and second phase voltages, means (18) for indicating the result of the comparison, **characterized in that** each of the means (16) for obtaining a signal representative of a phase voltage comprises two attachment lugs of different type (22, 22') and a cable (24) furnished at each end with an attachment terminal (26, 26') complementary to each of the lugs (22, 22') of said means (16).

2. Device according to Claim 1, in which the lugs (22, 22') of one and the same means for obtaining a signal representative of a phase voltage are mechanically different.

3. Device according to one of Claims 1 to 2, in which each lug (22, 22') is associated with an electronic processing system (20, 20') making it possible to provide data to the comparison means (14).

4. Device according to one of Claims 1 to 3, in which the first and second means (16) for obtaining a representative signal are identical.

5. Device according to one of Claims 1 to 4, in which the lugs (22, 22') of the first and second means (16) for obtaining a representative signal are aligned with a side of the casing (12) of the device.

6. Device according to one of Claims 1 to 5, in which the cables (24) are mounted captive on the casing (12) by way of fixing systems.

7. Device according to one of Claims 1 to 6, in which the means (18) for indicating the result of the comparison comprise a light-emitting diode located on a side of the casing (12), the lugs (22, 22') being located on another side, preferably opposite, of the casing (12).

8. Device according to Claim 7, comprising means (30) of powering and management of the diode (18) by way of the signals representative of the phase currents, said means (30) being adapted for powering the diode (18) in an intermittent manner, the second period separating two turned-on periods of the diode (18) having a duration of less than 50 ms.

9. Device according to Claim 8, comprising means of full-wave rectification.

10. Device according to one of Claims 8 or 9, in which the powering and management means (30) comprise means (28) for interrupting the current powering the diode (18) and energy storage means (32), said interrupting means (28) being controlled as a function of the energy available in the storage means (32).

11. Device according to Claim 10, in which the powering and management means are adapted so that, after the storage means (32) have been charged at least to a charge value (C₃₂), the powering of the diode (18) is carried out according to the iterative steps:
- turning on (B) during a first period during which the interrupting means (28) are conducting and the storage means (32) partially discharge so as to power the diode (18);
- recharging (C) during a second period during which the interrupting means (28) are not conducting and the storage means (32) recharge to the charge value (C₃₂).

12. Device according to one of Claims 10 or 11, in which the powering and management means (30) are electronic, the components of the electronic circuit of said means being adapted for defining the steps of the powering.

13. Device according to one of Claims 10 to 12, in which the storage means (32) are a capacitor and the interrupting means (28) are a transistor.
